# EUROPEAN PATENT SPECIFICATION

(11) **EP 1 670 967 B1**
(45) Date of publication and mention of the grant of the patent: **14.10.2009**
(21) Application number: 04782186.3
(22) Date of filing: 26.08.2004
(51) Int. Cl.: C23C 14/32, B23K 28/00, C23C 14/34

(54) **EXTENDED LIFE SPUTTER TARGET**
SPUTTERTARGET MIT LÄNGERER LEBENSDAUER
CIBLE DE PULVERISATION CATHODIQUE DE DUREE DE VIE PROLONGEE

(30) Priority: 09.09.2003 US 657085
(43) Date of publication of application: 21.06.2006
(73) Proprietor: Praxair S.T. Technology, Inc., North Haven, CT 06473 (US)
(72) Inventor: PERROT, Rene, F-31600 Eaunes (FR); HUNT, Thomas, J., Peekskill, NY 10566 (US); KOENIGSMANN, Holger, J., Congers, NY 10920 (US); GILMAN, Paul, S., Suffern, NY 10901 (US)
(74) Representative: Schwan - Schwan - Schorer
(86) International application number: PCT/US2004/027634
(87) International publication number: WO 2005/026406

(56) References cited:
- WO-A-00/15863
- WO-A-02/099157
- US-A- 5 215 639
- US-A- 5 226 469
- US-A- 5 674 367
- US-B2- 6 599 405

## Description

### Field of the Invention

This invention relates to the field of recessed sputter targets and particularly to a method of manufacturing recessed sputter targets.

### Background of the Invention

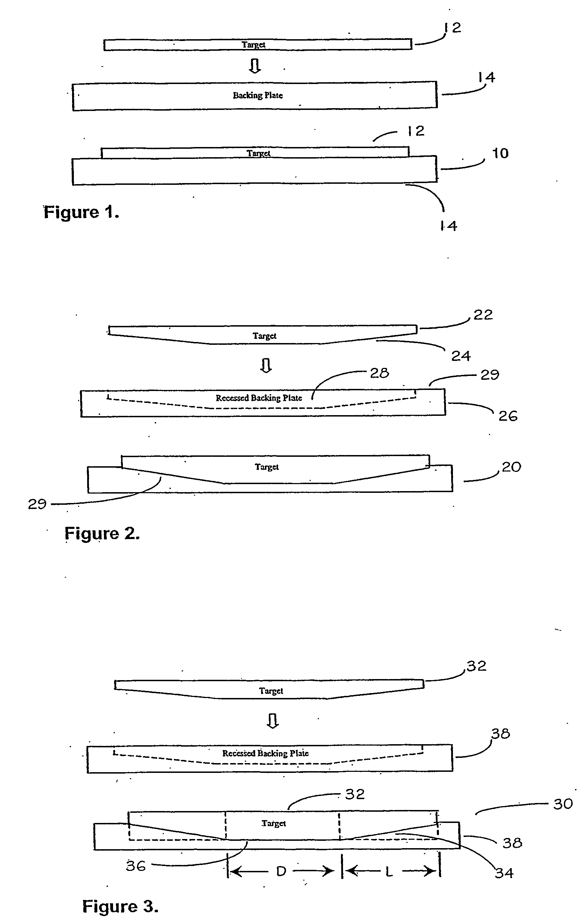

In the field of sputter target manufacture, various means bond the target material to the backing plate. Historically, target manufacturers soldered targets to backing plates. With reference to Fig. 1, conventional sputtering target assemblies 10 are formed by bonding target insert 12 to backing plate 14. As sputtering temperatures increased and target sizes increased, soldering failed to provide the necessary bond in view of the following disadvantages: 1) low melting temperatures limited chamber operating temperature; 2) the solder's high vapor pressure introduced impurities into the chamber; and 3) low bond strength, particularly at elevated temperatures, resulted in occasional bond failures. Since a debonded target can destroy not only a wafer, but also its supporting electrostatic chuck, it is most important to avoid bond failures. In fact, bond integrity is so important to sputter target manufacturers that Hunt et al., in US Pat. No. 6,092,427, developed a specialized method for preparing and testing bond interface evaluation samples. This method evaluates the strength of bonds between a sputter target and a backing plate. A sample of the material is removed through a first opening formed at one end and a threaded opening formed to split the first opening into two openings. Threading these openings and pulling the threaded openings measures the bond strength.

In view of the above problems, commercial target manufacturers have proposed several solutions for achieving a solid bond. For example, H. Zhang, in US Pat. No. 6,071,389, discloses the use of a titanium interlayer to diffusion bond a cobalt target to an aluminum or copper backing plate. The process deposits the titanium interlayer by electroplating, sputtering, electroless plating or plasma spraying. The deposited titanium bonds to both the cobalt and the backing plate material. This process also relies upon machining grooves into the target and backing plate to further improve bonding.

From WO-A-02/099157 there is known a method of manufacturing a sputter target assembly, in which method a target insert is manufactured which has a planar top surface and a conical-shaped rear surface; a backing plate is manufactured which has a cylindrical recess corresponding to the diameter of the target insert, the cylindrical recess having a depth less than the height of the target insert and a yield strength less than the yield strength of the target insert; and the target insert is pressed into the cylindrical recess of the backing plate to bond the target insert to the backing plate to form the target assembly.

Hunt et al., in US Pat. Nos. 5,836,506 and 6,073,830 disclose a method for roughening a cylindrical target's back and side surfaces and diffusion bonding the target's back and side surfaces to a backing plate. This method forms a solid state bond and has proven most effective for securing a target to a backing plate. Unfortunately, since the target sputters preferentially from the center, the cylindrical target's yield or use during sputtering is far less than one-hundred percent. The low yields resulting from preferential center region sputtering leave an opportunity for improved target utilization.

Thus, to develop sputter targets having improved yield and a requisite bond between the target insert and the backing plate, it is an object of the present invention to increase the sputter target material utilization, thereby reducing overall costs associated with the frequent design, manufacturing and changes of the sputter target assembly in the sputtering apparatus.

It is another object of the invention, to provide a sputter target assembly, having a satisfactory configuration and meeting the overall requirements of the semiconductor industry.

It is a further object of the invention, to provide a satisfactory solid state bond between the target insert and the backing plate of similar and dissimilar materials.

Other objects and advantages of the present invention will become apparent to one of ordinary skill in the art upon review of the specification, drawings and appended claims.

### Summary of the Invention

The foregoing objectives are met by the methods and apparatus of the present invention. In accordance with a first aspect of the invention, a method of manufacturing a sputter target assembly is provided. The method includes manufacturing a backing plate, the backing plate having a planar top surface and a cylindrical recess therein. The recess has a depth and a diameter, and the backing plate has a yield strength. Then a near final shape target insert is manufactured. The target insert has a frusta-conical rear surface that corresponds to the cylindrical recess of the backing plate and a frusta-conical front surface. The target insert further has a yield strength greater than that of the backing plate, and a height greater than the depth of the cylindrical recess in the backing plate. Thereafter, the target insert is hot pressed into the cylindrical recess of the backing plate to a state of plastic deformation so as to diffusion bond the target insert to the backing plate and form the target assembly. The target insert protrudes above the planar front surface of the backing plate.

In another aspect of the invention, a sputter target assembly is provided. The assembly includes a cylindrical backing plate having a planar front surface and a recess within the front surface and a target insert. The target insert has a height greater than the depth of the recess of the backing plate. The target insert has a frusta-conical shaped front surface and a rear surface, the rear surface having at least about fifty percent of its surface area conical-shaped and the rear surface being bonded to the backing plate to secure the target insert to the backing plate. The recess is plastically deformed to the shape of the target insert, to form the target assembly and the target insert protrudes above the planar front surface of the backing plate.

In a further aspect of the invention, a sputter target assembly is provided. The assembly includes a cylindrical backing plate, the cylindrical backing plate having a planar front surface and a recess within the front surface and a target insert bonded to the backing plate within the recess of the backing plate. The target insert has a frusta-conical shaped front surface and a frusta-conical shaped rear surface, the rear surface having at least about sixty percent of its surface area conical-shaped and the rear surface being bonded to the backing plate to secure the target insert to the backing plate. The recess is plastically deformed to the shape of the target insert, to form the target assembly.

### Description of the Drawings

The objects and advantages of the invention will become apparent from the following detailed description of the preferred embodiments thereof in connection with the accompanying drawings, in which:

Figure 1 is a schematic drawing that illustrates the process for manufacturing a conventional sputtering target assembly.

Figure 2 is a schematic drawing that illustrates the process of manufacturing an extended life sputter target assembly.

Figure 3 is a schematic cross-section of the target assembly of Figure 2.

Figure 4 is a schematic drawing illustrating the process of manufacturing an extended life target target assembly in accordance with another embodiment.

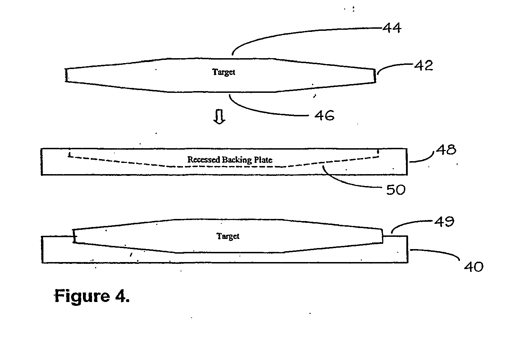

Although in Fig. 2 and 3 the target insert is illustrated with a planar front surface, in accordance with the present invention the target insert has a frusta-conical front surface, as it is illustrated in Fig. 4.

### Detailed Description of Preferred Embodiments Of the Invention

The invention provides a method for forming a sputter target assembly with a solid state bond. As illustrated in Figure 2, the process relies upon a target insert 22 having a conical-shaped rear surface 24 and a backing plate 26 having a partially mating cylindrical recess 28. Preferably the height of target insert 22 is higher than the depth of recess 28, thereby the target insert protrudes above planar surface 25 of backing plate 26. In this manner, the overall thickness of the target is increased from about 20 to about 35 percent, while the sputter target material available to be utilized increases from about 50 to about 100 percent over related target assemblies.

During the formation of the sputter target assembly target, insert 22 is pressed into the cylindrical recess 28 and deforms backing plate 26 forming the target/backing plate assembly 20. In this step, the frusta-conical surface 24 maintains its shape and forms the bond. This bond secures the conical or frusta-conical backside 24 of target insert 22 to the backing plate 26. The sputter life of the target assembly is lengthened to between about 1,400 and about 1,600 kWh, while a conventional target assembly would have a sputter life between about 1,000 and about 1,200 kWh.

The manufacturing method of producing the taper or angled surface 29 may include but is not limited to machining, forging, pressing, casting, hot isostatic pressing (HIP) powder and spinning. Advantageously, the process includes pressing the target insert directly into its conical or partially conical shape to eliminate the material loss experienced by machining. The most suitable method depends upon the target material. Many target materials are suitable for hot pressing or even cold pressing the target into shape. This avoids the machining step and increases yield. High yields are essentially important for high cost target materials, such as high purity tungsten and tantalum. For these materials, pressing the target assembly directly into its insert shape is the most advantageous route for producing the target. For these materials, this represents a clear cost and time savings over machining a tapered target insert to a surface corresponding to a tapered backing plate.

In addition, the use of high purity powders, such as tungsten powders, allows manufacturers to directly compress the powder directly into a target insert of near final shape.

Advantageously, maintaining the target insert and backing plate at a temperature of above 200°C for at least one hour during pressing improves bonding. Most advantageously, pressing occurs at a temperature of at least 400 °C to further improve bonding between the rear surface of the target insert and the backing plate.

The backing plate 26 contains a cylindrical recess 28 formed by machining the backing plate. Most advantageously, ductile metals or alloys, such as aluminum, copper, aluminum-base alloys or copper-base alloys form the backing plate. Aluminum base alloys, such as alloy 6061 provide the necessary ductility. In addition, the backing plate should have a yield strength less than the yield strength of the target material during pressing. Optionally, the backing plate recess 28 may contain square, tapered or rounded corners. The recess 28 has a volume approximately equal to the volume of the tapered insert 12. This provides sufficient bonding without inducing excessive deformation of the backing plate. Advantageously, recess 28 has a volume that is at least ninety percent of the volume of tapered insert 22 to prevent excessive deformation during pressing of tapered insert 22 into recess 28. Similarly, recess 28 advantageously has a volume of less than about one-hundred percent of the tapered insert 22 to allow sufficient pressing. Most advantageously, the recess 28 has a volume approximately equal to the tapered target insert's volume to limit stresses and maximize bonding.

Pressing the tapered target insert into the recess forms the target assembly. After pressing, the target material retains its original frusta-conical shape. This step relies upon hot pressing, such as vacuum hot pressing or a HIP process to form the final assembly. When the assembly is heated under pressure, the backing plate material reaches a state of plastic deformation that facilitates forming strong solid state bonds. High temperature pressing promotes the reaction of the target material with the backing plate. For some systems, i.e. a titanium target and an aluminum backing plate it is advantageous to diffuse and react the materials together to form reaction products that contribute to the bond strength.

After pressing, the target assembly is ready for finishing operations such as final target machining, polishing, cleaning and machining threaded mounting openings into the backing plate.

As illustrated in Figure 3, the target assembly 30 advantageously contains target insert 32 bonded along conical interface 34 and frustum interface 36 to backing plate 38. The frustum interface has a diameter D and the conical interface forms a ring of length L. The length L extends parallel to the frustum interface 36. The frustum interface 36 consists of at least about fifty percent of the bond surface area between the target insert and the backing plate. Most advantageously, it consists of at least about sixty percent of the total bond surface area of the target insert. The target uses up to approximately about fifteen percent and as high as twenty percent less material to reduce manufacturing cost and achieve the same utilization and settings as a standard target assembly.

Figure 4 illustrates a target insert 42 having a frusta-conical configuration of target assembly 40 on both the front and rear surfaces.

The bond interface does not lend itself to the use of mating machined grooves, since machined grooves could interfere with the plastic deformation of the backing plate. Advantageously however, a surface treatment step roughens the side and tapered surface of the target insert and the cylindrical recess to form an uneven surface topography to the surface to be bonded. Acceptable surface roughening techniques include, but are not limited to, particle blasting, shot peening and etching. Particles used in particle blasting can be selected from a group that may include but is not limited to: grit, sand, glass beads and steel shot. This process causes a subtle disruption of the associated bonding surface when the components are heated during pressing. Most advantageously, the process uses grit blasting to roughen the target insert to promote the formation of the desirable solid state bonding.

The near final shape target insert 42 has a frusta-conical rear shape which mates with backing plate 48 along the aforementioned interface 50. In accordance with this embodiment, the near final shape target insert 42 has a tapered or angled front surface 44. The front surface is preferably frusta-conical. Additionally, target insert 42 has a yield strength greater than that of backing plate 48, and a height greater than the depth of the cylindrical recess in backing plate 48. As discussed above, the materials utilized for the backing plate and the target insert may be any one of the ones mentioned with respect to the previous embodiment. Upon pressing target insert 42 into backing plate 48 via a hot press process (e.g., vacuum hot pressing, HIP process) the backing plate material reaches a state of plastic deformation forming a strong bond therebetween. The final sputter target assembly has the target insert protruding above the planar surface 49 of backing plate 48. Accordingly, the sputter life of the target is increased to 2,400 kWh, as opposed to a conventional target assembly which provides a sputter life of about 1,000 to 1,200 kWh. The method and the sputter target assembly of the present invention will be further described in detail with reference to the following example which, however, shall not be construed as limiting the invention.

### Example

A commercial 99.99 percent pure titanium disk having dimensions of 13.572" (34.5 cm) diameter x .750" (1.9 cm) thickness had a 3° angle machined on the rear bonding surface. The disk's rear bonding surface formed a cone-like shape. The titanium disk was placed in a cylindrical recess machined into a 6061-T6 aluminum disk. The recess contained a volume equal to the volume of the titanium target insert. A HIP process for 2 hours, at 15 ksi (103 MPa), at a temperature of 510 °C, bonded the insert to the backing plate. The aluminum disk became plastic during the HIP cycle and conformed to the shape of the tapered titanium target's 3° angle. The plastic deformation that occurred during the HIP process ensured a secure solid state bond. Evaluating this bond by ultrasonic testing, tensile testing and metallographic methods confirmed the bond integrity and strength.

Post HIP ultrasonic testing analysis revealed a one hundred percent bond between the backing plate and the target. In addition, the ultrasonic testing indicated a minor void in the area at the edge of the target.

Metallographic analysis revealed a consistent bond interface with one small void resulting from the square corner of the recessed backing plate not fully extruding or deforming. The location and size of this void would have no impact upon the target's performance. Furthermore, the bottom and side wall bond were equivalent to integral solid state bonding achieved with diffusion bonding techniques. In addition, subsequent testing has shown that a fillet located at the side wall of the recess eliminates any voids.

Two tensile tests in accordance with the two threaded opening sample method confirmed the excellent bond. Both samples, cut across the bond interface, had the aluminum fracture. The first sample fractured at 1,920 lbs. (13.2 MPa). The second sample fractured at 1,830 lbs. (12.6 MPa).

While an example is given for titanium targets, it is noteworthy that this process operates with similar effectiveness on sputter targets of any alloy or composition that is suitable for use as a sputter target such as, aluminum, titanium, copper, chromium, cobalt, nickel and tantalum. In addition, this process operates with the target material and backing plate being either similar or dissimilar alloys. For example, it is possible to place an aluminum-alloy target in an aluminum backing plate or in a copper backing plate.

The tapered target design uses a manufacturing-friendly process to recess the corresponding backing plate and easily adapts to various types of manufacturing equipment. The process also eliminates the need for special-cost-intensive machining of the backing plate blank and reduces the time required for manufacturing. Furthermore, it allows for the manufacture of a sputter target with a decreased thickness at its edges (typically 20 - 35%). Since this target assembly sputters preferentially from its center, this target requires no change in standard operating conditions. Optionally, the design increases the thickness of the target material without modification of a sputtering system's standard sputter procedure in comparison to a conventional cylindrical target insert. Furthermore, it increases sputter tool productivity by lowering the amount of target material required, thereby reducing cost. Finally, the process also facilitates the forming of strong vacuum compatible bonds. These bonds can have more strength than the actual backing plate itself. Finally, the process reduces the design and manufacturing time required for new designs and products.

## Claims

1. A method of manufacturing a sputter target assembly comprising the steps of:
a) manufacturing a backing plate, the backing plate having a planar top surface and a cylindrical recess therein, the recess having a depth and a diameter, and the backing plate having a yield strength;
b) manufacturing a near final shape target insert, wherein the target insert has a frusta-conical rear surface that corresponds to the cylindrical recess of the backing plate and a frusta-conical front surface, the target insert further having a yield strength greater than that of the backing plate, and a height greater than the depth of the cylindrical recess in the backing plate; and
c) hot pressing the target insert into the cylindrical recess of the backing plate to a state of plastic deformation so as to diffusion bond the target insert to the backing plate and form the target assembly, where the target insert protrudes above the planar front surface of the backing plate.

2. The method of claim 1 wherein at least fifty percent of the frusta-conical rear surface bonds to the backing plate.

3. The method of claim 1 including the additional step of maintaining the temperature of the target insert and backing plate above 200 °C for at least one hour to improve bonding between the frusta- conical rear surface of the target insert and the backing plate.

4. The method of claim 1 wherein the cylindrical recess has a volume and the target insert has a volume; and the cylindrical recess has a volume between about ninety and about one-hundred percent of the volume of the target insert.

5. A sputter target assembly comprising:
a cylindrical backing plate, the cylindrical backing plate having a planar front surface and a recess within the front surface; and
a target insert having a height greater than the depth of the recess of the backing plate, the target insert having a frusta-conical shaped front surface and a rear surface, the rear surface having at least about fifty percent of its surface area conical-shaped and the rear surface being bonded to the backing plate to secure the target insert to the backing plate, wherein the recess is plastically deformed to the shape of the target insert, to form the target assembly and where the target insert protrudes above the planar front surface of the backing plate.

6. The sputter target of claim 5 wherein the recess has a shape conformed to the shape of the target insert.

7. The sputter target of claim 5 wherein a conical interface bonds the target insert to the backing plate.

8. A sputter target assembly comprising:
a cylindrical backing plate, the cylindrical backing plate having a planar front surface and a recess within the front surface; and
a target insert bonded to the backing plate within the recess of the backing plate, the target insert having a frusta-conical shaped front surface and a frusta-conical shaped rear surface, the rear surface having at least about sixty percent of its surface area conical-shaped and the rear surface being bonded to the backing plate to secure the target insert to the backing plate and form the target assembly, wherein the recess is plastically deformed to the shape of the target insert, to form the target assembly.

9. The sputter target of claim 8 wherein the recess has a shape conformed to the shape of the target insert.

10. The sputter target of claim 8 wherein the front surface of the target insert protrudes above the planar top surface of the backing plate.

## Patentansprüche

1. Verfahren zum Herstellen einer Sputter-Target-Baugruppe mit den Schritten:
a) Herstellen einer Trägerplatte, wobei die Trägerplatte eine ebene, obere Oberfläche und eine zylindrische Ausnehmung darin aufweist, wobei die Ausnehmung über eine Tiefe und einen Durchmesser verfügt und wobei die Trägerplatte eine Streckfestigkeit hat;
b) Herstellen eines Target-Einsatzes mit nahezu endgültiger Form, wobei der Target-Einsatz eine kegelstumpfförmige Rückseite aufweist, die der zylindrischen Ausnehmung der Trägerplatte entspricht, sowie eine kegelstumpfförmige Vorderseite, wobei der Target-Einsatz ferner eine Streckfestigkeit aufweist, die größer als jene der Trägerplatte ist und eine Höhe aufweist, die größer als die Tiefe der zylindrischen Ausnehmung in der Trägerplatte ist; und
c) Heißpressen des Target-Einsatzes in die zylindrische Ausnehmung der Trägerplatte, bis ein Zustand plastischer Verformung erreicht ist, um so für eine Diffusionsverbindung des Target-Einsatzes mit der Trägerplatte zu sorgen und die Target-Baugruppe auszubilden, wobei der Target-Einsatz über die ebene Vorderseite der Trägerplatte hinausragt.

2. Verfahren gemäß Anspruch 1, bei welchem mindestens 50% der kegelstumpfförmigen Rückseite eine Bindung mit der Trägerplatte eingeht.

3. Verfahren gemäß Anspruch 1, welches den zusätzlichen Schritt des Haltens der Temperatur des Target-Einsatzes und der Trägerplatte auf über 200 °C für mindestens eine Stunde aufweist, um die Bindung zwischen der kegelstumpfförmigen Rückseite des Target-Einsatzes und der Trägerplatte zu verbessern.

4. Verfahren gemäß Anspruch 1, bei welchem die zylindrische Ausnehmung ein Volumen aufweist, und der Target-Einsatz ein Volumen aufweist, wobei die zylindrische Ausnehmung ein Volumen zwischen etwa 90 und etwa 100 % des Volumens des Target-Einsatzes aufweist.

5. Sputter-Target-Baugruppe mit:
einer zylindrischen Trägerplatte, die eine ebene Vorderseite und eine Ausnehmung innerhalb der Vorderseite aufweist; und
einem Target-Einsatz mit einer Höhe, die größer als die Tiefe der Ausnehmung der Trägerplatte ist, wobei der Target-Einsatz eine kegelstumpfförmige Vorderseite und eine Rückseite aufweist, wobei mindestens etwa 50 % des Oberflächenbereichs der Rückseite kegelstumpfförmig sind und die Rückseite mit der Trägerplatte verbunden ist, um den Target-Einsatz an der Trägerplatte zu befestigen, wobei die Ausnehmung auf die Form des Target-Einsatzes plastisch verformt wird, um die Target-Baugruppe zu bilden und wobei der Target-Einsatz über die ebene Vorderseite der Trägerplatte hervorsteht.

6. Sputter-Target gemäß Anspruch 5, bei welchem die Ausnehmung eine Form aufweist, die der Form des Target-Einsatzes angepasst ist.

7. Sputter-Target gemäß Anspruch 5, bei welchem eine konische Grenzfläche den Target-Einsatz mit der Trägerplatte verbindet.

8. Sputter-Target-Baugruppe versehen mit:
einer zylindrischen Trägerplatte, die eine ebene Vorderseite und eine Ausnehmung innerhalb der Vorderseite aufweist; und
einem Target-Einsatz, der innerhalb der Ausnehmung der Trägerplatte mit der Trägerplatte verbunden ist, wobei der Target-Einsatz eine kegelstumpfförmige Vorderseite und eine kegelstumpfförmige Rückseite aufweist, wobei mindestens etwa 60% des Oberflächenbereichs der Rückseite konisch geformt sind und die Rückseite mit der Trägerplatte verbunden ist, um den Target-Einsatz an der Trägerplatte zu befestigen und die Target-Baugruppe zu bilden, wobei die Ausnehmung auf die Form des Target-Einsatzes plastisch verformt wurde, um die Target-Baugruppe zu bilden.

9. Sputter-Target gemäß Anspruch 8, bei welchem die Ausnehmung eine Form aufweist, die der Form des Target-Einsatzes angepasst wurde.

10. Sputter-Target gemäß Anspruch 8, bei welchem die Vorderseite des Target-Einsatzes über die ebene Oberseite der Trägerplatte hinausragt.

## Revendications

1. Procédé de fabrication d'un agencement cible de pulvérisation comprenant les étapes de :
a) fabrication d'une plaque d'appui, la plaque d'appui ayant une surface supérieure plane et un évidement cylindrique en son sein, l'évidement ayant une profondeur et un diamètre, et la plaque d'appui ayant une limite d'élasticité ;
b) fabrication d'un insert cible ayant presque sa forme finale, l'insert cible ayant une surface arrière tronconique qui correspond à l'évidement cylindrique de la plaque d'appui et une surface avant tronconique, l'insert cible ayant, en outre, une limite d'élasticité supérieure à celle de la plaque d'appui, et une hauteur supérieure à la profondeur de l'évidement cylindrique dans la plaque d'appui ; et
c) pressage à chaud de l'insert cible dans l'évidement cylindrique de la plaque d'appui jusqu'à un état de déformation plastique afin de lier par diffusion l'insert cible à la plaque d'appui et former l'agencement cible, l'insert cible faisant saillie au-dessus de la surface avant plane de la plaque d'appui.

2. Procédé selon la revendication 1, dans lequel au moins 50 % de la surface arrière tronconique se lie à la plaque d'appui.

3. Procédé selon la revendication 1, comprenant l'étape supplémentaire de maintien de la température de l'insert cible et de la plaque d'appui à plus de 200°C pendant au moins une heure pour améliorer la liaison entre la surface arrière tronconique de l'insert cible et la plaque d'appui.

4. Procédé selon la revendication 1, dans lequel l'évidement cylindrique a un volume et l'insert cible a un volume ; et l'évidement cylindrique a un volume compris entre environ 90 % et environ 100 % du volume de l'insert cible.

5. Agencement cible de pulvérisation comprenant :
une plaque d'appui cylindrique, la plaque d'appui cylindrique ayant une surface avant plane et un évidement au sein de la surface avant ; et
un insert cible ayant une hauteur supérieure à la profondeur de l'évidement de la plaque d'appui, l'insert cible ayant une surface avant de forme tronconique et une surface arrière, la surface arrière ayant au moins environ 50 % de sa superficie de forme tronconique et la surface arrière étant liée à la plaque d'appui pour fixer l'insert cible à la plaque d'appui, l'évidement étant déformé plastiquement en la forme de l'insert cible, pour former l'agencement cible et l'insert cible faisant saillie au-dessus de la surface avant plane de la plaque d'appui.

6. Agencement cible de pulvérisation selon la revendication 5, dans lequel l'évidement a une forme épousant la forme de l'insert cible.

7. Agencement cible de pulvérisation selon la revendication 5, dans lequel une interface conique lie l'insert cible à la plaque d'appui.

8. Agencement cible de pulvérisation comprenant :
une plaque d'appui cylindrique, la plaque d'appui cylindrique ayant une surface avant plane et un évidement au sein de la surface avant ; et
un insert cible lié à la plaque d'appui au sein de l'évidement de la plaque d'appui, l'insert cible ayant une surface avant de forme tronconique et une surface arrière de forme tronconique, la surface arrière ayant au moins environ 60 % de sa superficie de forme tronconique et la surface arrière étant liée à la plaque d'appui pour fixer l'insert cible à la plaque d'appui et former l'agencement cible, l'évidement étant déformé plastiquement en la forme de l'insert cible, pour former l'agencement cible.

9. Agencement cible selon la revendication 8, dans lequel l'évidement a une forme épousant la forme de l'insert cible.

10. Agencement cible selon la revendication 8, dans lequel la surface avant de l'insert cible fait saillie au-dessus de la surface supérieure plane de la plaque d'appui.
